# EUROPEAN PATENT SPECIFICATION

(11) **EP 2 700 101 B1**
(45) Date of publication and mention of the grant of the patent: **10.06.2015**
(21) Application number: 11716526.6
(22) Date of filing: 21.04.2011
(51) Int. Cl.: H01L 25/11, H01L 23/62, H01L 23/40

(54) **Clamping failure detector for thyristor clamped assemblies**
Spannfehlerdetektor für eingespannten Thyristoranordnungen
Serrage détecteur de défaillance pour des assemblages bridés de thyristors

(43) Date of publication of application: 26.02.2014
(73) Proprietor: ALSTOM Technology Ltd, 5400 Baden (CH)
(72) Inventor: DAVIDSON, Colin, Charnock, Stafford, Staffordshire ST17 0JZ (GB); TRAINER, David, Reginald, Alvaston, Derbyshire DE24 0AG (GB)
(74) Representative: Ahner, Philippe
(86) International application number: PCT/EP2011/056454
(87) International publication number: WO 2012/143060

(56) References cited:
- WO-A1-94/18649
- JP-A- 58 075 468
- H-J SCHULZE ET AL: "High voltage thyristors for HVDC and other applications: Light triggering combined with self protection functions", INTERNET CITATION, 1 January 2003 (2003-01-01), pages 47-52, XP009151421, Retrieved from the Internet: URL:http://www.igbt.cn/admin/productfile/H IGH-VOLTAGE%20THYRISTORS.pdf [retrieved on 2011-08-22]

## Description

This invention relates to a clamping failure detector, a clamping failure detector assembly, and a method of detecting a clamping failure in at least one thyristor clamped assembly.

WO94/18649 describes a movement detector assembly comprising: a bendable electromagnetic radiation conduit in the form of an optical fiber extending between stationary objects; an electromagnetic radiation source arranged in communication with a first end of the conduit; and an electromagnetic radiation detector arranged in communication with a second end of the conduit, the conduit bending on movement of the stationary objects away from one another to modify the transmission of electromagnetic radiation from the electromagnetic radiation source to the electromagnetic radiation detector; and the electromagnetic radiation detector indicating a movement when the electromagnetic radiation transmitted from the electromagnetic radiation source is modified.

High-power thyristors that form part of thyristor valves for use in High Voltage Direct Current (HVDC) systems and Flexible Alternating Current Transmission Systems (FACTS) need to clamped at high pressure between respective pairs of heatsinks. A typical clamping pressure is 12.5Mpa, which equates to a clamping force of 135kN for a 115mm diameter thyristor.

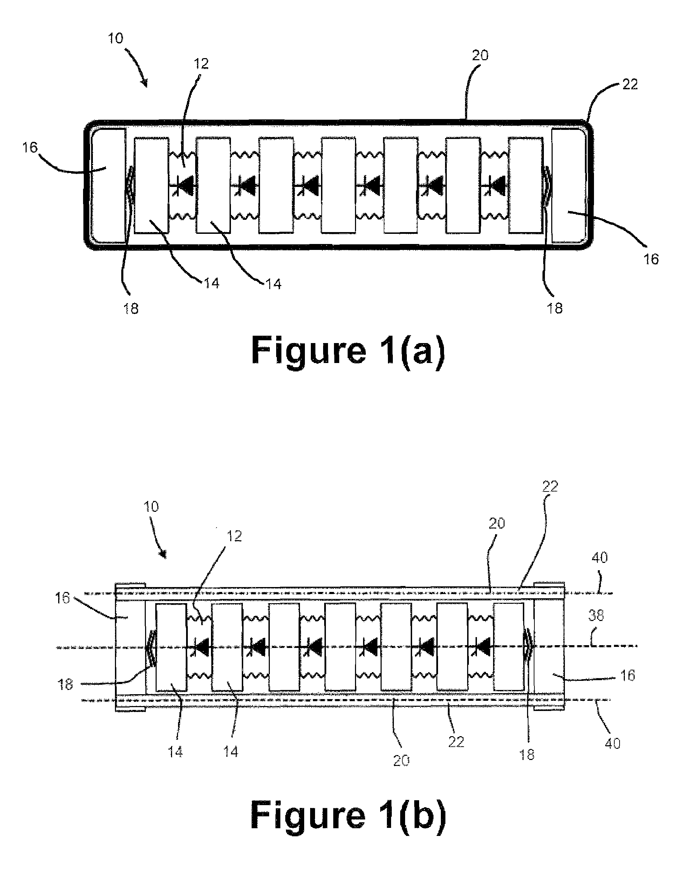

A common arrangement of such thyristors and heatsinks is a, so-called, "thyristor clamped assembly" which is shown schematically in Figures 1(a) and 1(b).

The thyristor clamped assembly 10 includes a series-connected stack of thyristors 12 each of which is located between a pair of heatsinks 14. The arrangement shown includes six thyristors 12 but the number of thyristors can be larger or smaller than six. The heatsinks are water-cooled although other methods of cooling are also possible.

Each end of the thyristor clamped assembly 10 is defined by a plate 16 against which abuts a spring member 18 to bias the respective thyristors 12 and heatsinks 14 into compressive engagement with one another.

Respective tensile members 20 extend at either side of the thyristor clamped assembly 10 to hold the plates 16 in compressive engagement with the stack of thyristors 12.

Typically each tensile member 20 is defined by a high-strength, fibre-reinforced composite, clamping band 22.

The very large clamping force exerted by each clamping band 22 means that failure, i.e. snapping, of the band 22 can occur. Failure of a tensile member 20 results in at least a partial loss of the clamping force applied to the stack of thyristors 12.

A partial loss of clamping force during operation of the thyristor clamped assembly 10, i.e. while the thyristor valve in which the thyristor clamped assembly 10 is located carries current, results in the internal thermal impedance of each thyristor 12 increasing rapidly. Such a rapid increase in internal thermal impedance causes the thyristors 12 to overheat and fail within a few tens of seconds of further operation.

A complete loss of clamping force during operation of the thyristor clamped assembly 10 results in the structural collapse of the thyristor clamped assembly 10 with respective thyristors separating from one another. Separation of the thyristors creates an open circuit within the associated thyristor valve and the very high voltage at which such thyristor valves normally operate means that the open circuit cannot be sustained for long. Instead a power arc, which may bypass the thyristors 12, develops. Power arcs generate a huge amount of energy very quickly and therefore pose a serious fire risk.

There is a need, therefore, for improvements to existing thyristor clamped assemblies which, in the event of a loss of clamping force, allow one or more mitigating steps to be carried out to reduce the likelihood of subsequent thyristor failure and/or fire.

According to a first aspect of the invention there is provided a clamping failure detector, for a thyristor clamped assembly, comprising:
a frangible electromagnetic radiation conduit in the form of an optical fibre extending between first and second end plates of at least one thyristor clamped assembly;
an electromagnetic radiation source arranged in communication with a first end of the frangible conduit; and
an electromagnetic radiation detector arranged in communication with a second end of the frangible conduit,
the frangible conduit being rupturable on movement of the first and second end plates of the or each thyristor clamped assembly away from one another to interrupt the transmission of electromagnetic radiation from the electromagnetic radiation source to the electromagnetic radiation detector; and
the electromagnetic radiation detector being configured to indicate a clamping failure when the electromagnetic radiation transmitted from the electromagnetic radiation source is interrupted.

The provision of a frangible electromagnetic radiation conduit allows a loss of clamping force, i.e. a mechanical failure resulting in the movement of first and second end plates of a thyristor clamped assembly away from one another, to be converted via rupture of the frangible conduit into an interruption of electromagnetic radiation transmission that is readily detected.

Such rupturing allows a mitigating step, e.g. tripping of the input energy source to the thyristor valve, to be taken before a thyristor overheats and fails or before a fire breaks out.

According to a second aspect of the invention there is provided a clamping failure detector assembly comprising:
a frangible electromagnetic radiation conduit extending between first and second end plates of at least one thyristor clamped assembly;
an electromagnetic radiation source arranged in communication with a first end of the frangible conduit; and
an electromagnetic radiation detector arranged in communication with a second end of the frangible conduit,
the frangible conduit rupturing on movement of the first and second portions of the or each thyristor clamped assembly away from one another to interrupt the transmission of electromagnetic radiation from the electromagnetic radiation source to the electromagnetic radiation detector; and
the electromagnetic radiation detector indicating a clamping failure when the electromagnetic radiation transmitted from the electromagnetic radiation source is interrupted.

As above the provision of a frangible electromagnetic radiation conduit allows the rupture of the frangible conduit to initiate a mitigating step, e.g. tripping of the input energy source to the thyristor valve, before a thyristor overheats and fails or before a fire breaks out.

Preferably the frangible conduit is wrapped around the or each thyristor clamped assembly. Wrapping the frangible conduit around the or each thyristor clamped assembly can be achieved relatively inexpensively as no additional elements are required, while helping to ensure that the frangible conduit ruptures when the first and second end plates of the associated thyristor clamped assembly move away from one another.

Optionally the frangible conduit is fixedly secured to each of the first and second portions of the or each thyristor clamped assembly. Fixedly securing the frangible conduit to the first and second end plates provides a straight forward way of helping to ensure that the frangible conduit ruptures when the first and second end plates move away from one another and, in some instances, can avoid the need to wrap the frangible conduit around the or each thyristor clamped assembly which might otherwise prove cumbersome.

In a preferred embodiment of the invention each of the first and second end plates of a respective thyristor clamped assembly lies at or adjacent to a respective end of the thyristor clamped assembly. Such an arrangement maximises the amount of relative movement between the first and second end plates for a given loss of clamping force, and so helps to ensure rupturing of the frangible conduit.

The frangible conduit may extend between the first and second end plates of the or each thyristor clamping assembly on or adjacent to a midline extending along a middle of the corresponding thyristor clamping assembly. First and second portions of a thyristor clamped assembly lying along such a midline will move away from one another in the event that a tensile member, i.e. clamping band, at either side of the clamped assembly fails, and so arranging the frangible conduit in the foregoing manner helps to ensure that a single frangible conduit ruptures in the event that either of the tensile members fails.

In another preferred embodiment of the invention the frangible conduit extends between the first and second end plates of the or each thyristor clamped assembly on or adjacent to a tensile member line lying coincident with a tensile member acting to clamp the corresponding thyristor clamped assembly together. Such an arrangement helps to ensure that the frangible conduit ruptures when the given tensile member fails.

Optionally the frangible conduit includes a plurality of interconnected frangible conduit portions, each frangible conduit portion being associated with a respective thyristor clamped assembly. The inclusion of a plurality of frangible conduit portions facilitates installation and maintenance of the invention.

The frangible conduit is in the form of an optical fibre. An optical fibre is electrically insulating and so can be used safely in proximity to, e.g. a high voltage thyristor valve.

The electromagnetic radiation source may emit radiation in the visible and/or infrared electromagnetic spectrum. Such an arrangement is readily deployable and has low power requirements since no additional systems, such as cooling, are required.

In a further preferred embodiment of the invention the electromagnetic radiation source is or includes an LED. LEDs are readily available and relatively inexpensive. In addition their operation does not normally represent a risk of injury to a human operative or maintenance technician.

Conveniently the electromagnetic radiation detector is a visible and/or infrared radiation detector.

According to a third aspect of the invention there is provided a method of detecting a clamping failure in at least one thyristor clamped assembly comprising the steps of:
(a) extending a frangible electromagnetic radiation conduit between first and second end plates of the or each thyristor clamped assembly and configuring the frangible conduit to rupture on movement of the first and second end plates of the or each thyristor clamped assembly away from one another;
(b) arranging an electromagnetic radiation source in communication with a first end of the frangible conduit;
(c) arranging an electromagnetic radiation detector in communication with a second end of the frangible conduit; and
(d) indicating a clamping failure when electromagnetic radiation transmitted from the electromagnetic radiation source to the electromagnetic radiation detector is interrupted on rupture of the frangible conduit.

The method of the invention shares the advantages associated with the first and second aspects of the invention mentioned hereinabove.

There now follows a brief description of preferred embodiments of the invention, by way of non-limiting examples, with reference to the accompanying drawings in which:
Figure 1 (a) shows an elevational view from a first side of a conventional thyristor clamped assembly;
Figure 1(b) shows a plan view from above of the thyristor clamped assembly shown in Figure 1(a);
Figure 2 shows a clamping failure detector assembly according to a first embodiment of the invention;
Figure 3 shows a variant of the clamping failure detector assembly shown in Figure 2;
Figure 4 shows the clamping failure detector assembly shown in Figure 2 in a first failure mode;
Figure 5 shows a clamping failure detector assembly according to a second embodiment of the invention; and
Figure 6 shows a clamping failure detector assembly according to a third embodiment of the invention.

A clamping failure detector assembly according to a first embodiment of the invention is designated generally by the reference numeral 30.

The detector assembly 30 includes a frangible electromagnetic radiation conduit 32, in the form of an optical fibre 42, which extends between first and second end plates 34, 36 of a first thyristor clamped assembly 10a.

In particular, in the embodiment shown, the frangible conduit 32 is wrapped around the thyristor clamped assembly 10a for one and a quarter turns. In other embodiments (not shown) the frangible conduit may be wrapped around the thyristor clamped assembly 10a for greater than or fewer than one and a quarter turns.

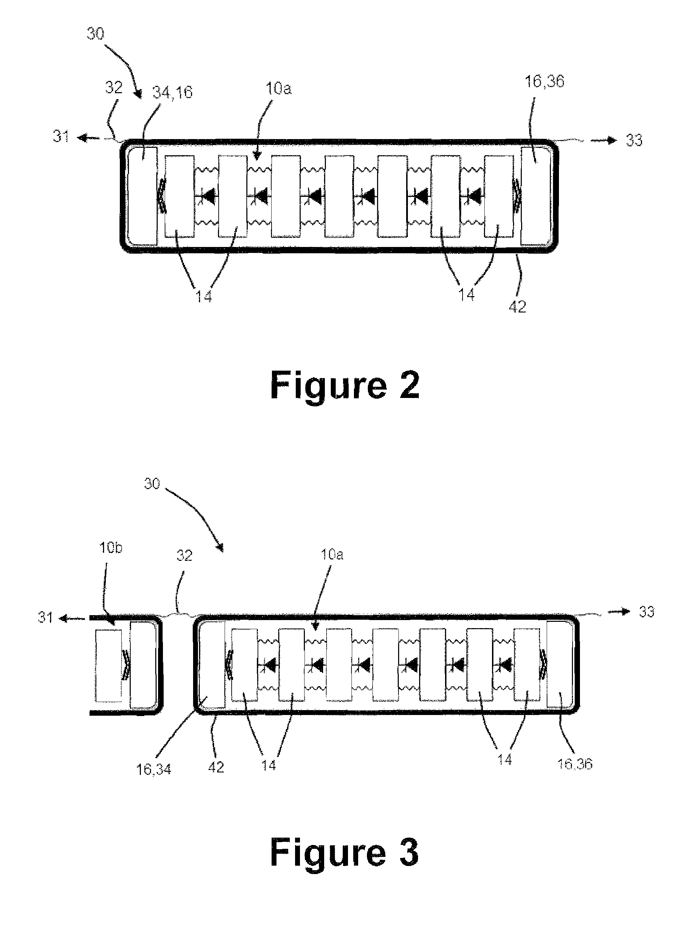

In still further embodiments of the invention the frangible conduit 32 may be additionally wrapped around a second thyristor clamped assembly 10b, as partially illustrated in Figure 3. The length of frangible conduit 32 extending between the first and second thyristor clamped assemblies 10a, 10b does so in a relaxed state so as to minimise the likelihood of a false indication of a clamping failure arising.

Returning to the detector assembly 30 shown in Figure 2, each of the first and second end plates 34, 36 lies at a respective end of the thyristor clamped assembly 10, and more specifically lies on a respective plate 16 at either end of the thyristor clamped assembly 10.

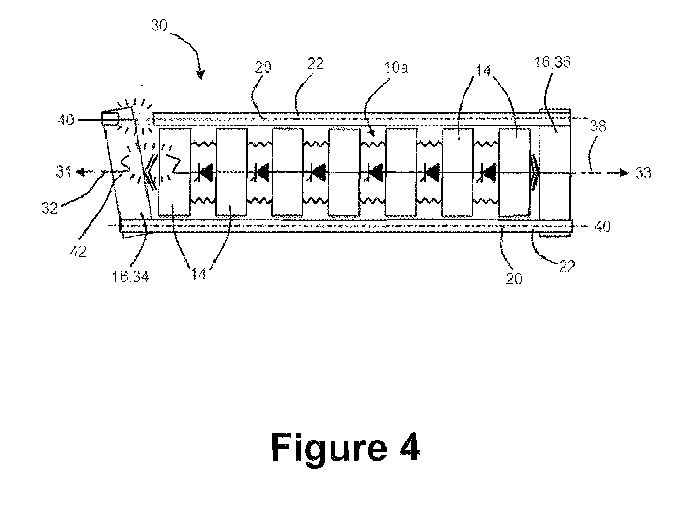

The frangible conduit 32 is wrapped around the thyristor clamped assembly 10a along a midline 38 (as illustrated in Figures 1(b) and 4) which extends down a middle of the thyristor clamped assembly 10.

In other embodiments of the invention (not shown) the frangible conduit 32 extends between the first and second end plates 34, 36 on or adjacent to a tensile member line 40 (as illustrated in Figures 1(b) and 4) which lies coincident with the tensile member 20 that acts to clamp the thyristor clamped assembly 10a together. In some such embodiments the frangible conduit 32 may form a part of or be integrally formed with a composite band 22 that defines the tensile member 20.

The detector assembly 30 also includes an electromagnetic radiation source 31 that is arranged in communication with a first end of the frangible conduit 32, and an electromagnetic radiation detector 33 which is arranged in communication with a second end of the frangible conduit 32.

The electromagnetic radiation source 31 is an LED that emits radiation in the visible electromagnetic spectrum. In other embodiments of the invention the electromagnetic radiation source may emit radiation in the infrared electromagnetic spectrum, or another electromagnetic radiation spectrum.

The electromagnetic radiation detector 33 is a visible radiation detector in the form of an optical receiver. In other embodiments of the invention the electromagnetic radiation detector may be an infrared radiation detector.

Each of the electromagnetic radiation source and detector 31,33 is located in a protection cabinet (not shown) which is spaced from the thyristor clamped assembly 10 and conveniently located at ground potential.

In other embodiments (not shown) the electromagnetic radiation source and detector 31,33 are mounted on one or more thyristor drive units, each of which is located adjacent to a respective thyristor 12. Such drive units are self-powered and isolated from ground, and so reduce the need for a long length of frangible conduit 32.

In use the electromagnetic radiation source 31 emits radiation in the visible electromagnetic spectrum, i.e. light, which is transmitted by the frangible conduit 32 to the electromagnetic radiation detector 33.

In the event that one or both of the tensile members 20 fails the detector assembly 30 functions as follows.

Snapping of one tensile member 20, as illustrated schematically in Figure 4, can result in one side of a plate 16 moving away from the adjacent heatsink 14 which leads to a partial loss of clamping force.

Movement of the plate causes the first and second end plates 34, 36 to move away from one another. Such movement of the first and second end plates 34 ruptures the frangible conduit 32 that extends between the first and second end plates 34, 36, and so interrupts the transmission of light to the electromagnetic radiation detector 33.

On such interruption the electromagnetic radiation detector 33 indicates that a clamping failure has occurred and initiates a mitigating step in the form of tripping the input energy source supplied to the thyristor clamped assembly 10.

As well as a partial loss of clamping force as set out above, snapping of one or both of the tensile members 20 can lead to the whole of one plate 16 moving away from the adjacent heatsink 14 which leads to a complete loss of clamping force.

Under such circumstances the first and second portions 34, 36 again move away from one another causing rupture of the frangible conduit 32 and a resulting interruption in the transmission of light from the LED, i.e. the electromagnetic radiation source 31, to the optical receiver, i.e. the electromagnetic radiation detector 33.

Accordingly the electromagnetic radiation detector 33 again indicates that a clamping failure has occurred and a mitigation step is initiated.

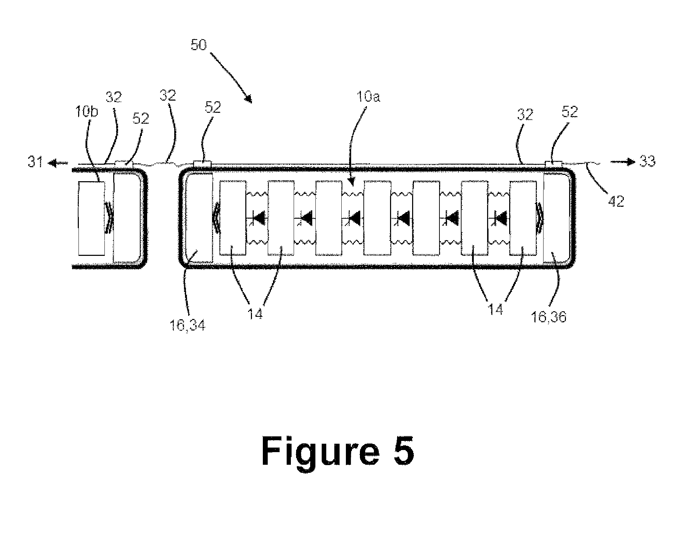

A clamping failure detector assembly 50 according to a second embodiment of the invention is illustrated schematically in Figure 5.

The second detector assembly 50 is similar to the first detector assembly 30 and like features share the same reference numerals.

The second detector assembly 50 includes a frangible conduit 32, in the form of an optical fibre 42, which extends between first and second end plates 34, 36 located on respective plates 16 of a first thyristor clamped assembly 10a.

The frangible conduit 32 extends only between the first and second end plates 34, 36 and is not wrapped around the first thyristor clamped assembly 10a. In contrast to the first detector assembly 30 the frangible conduit 32 is fixedly secured to the thyristor clamped assembly 10 at each of the first and second end plates 34, 36. A clamp plate 52 provides the desired fixing.

The frangible conduit 32 extends to a second thyristor clamped assembly 10b (partially illustrated in Figure 5) and is fixedly secured to the first and second portions 34, 36 thereof (only the second portion 36 of the second thyristor clamped assembly 10b is shown) by a further clamp plate 52.

In other embodiments of the invention the frangible conduit 32 only extends between first and second end plates 34, 36 of a single thyristor clamped assembly 10a.

Preferably the length of frangible conduit lying between the first and second thyristor clamped assemblies 10a, 10b extends in a relaxed state so as to minimise the likelihood of a false indication of a clamping failure arising.

In use the second detector assembly 50 functions in a similar manner to the first detector assembly 30.

In the event that one or both of the tensile members 20 fails the first and second end plates 34, 36 again move away from one another and the frangible conduit 32 is ruptured.

This interrupts the transmission of light to the optical receiver, i.e. the electromagnetic radiation detector 33, which therefore indicates a clamping failure and initiates a mitigation step.

A clamping failure detector assembly according to a third embodiment of the invention is designated generally by the reference numeral 70.

The third detector assembly 70 shares similar features with each of the first and second detector assemblies 30; 50 and these are indicated with the same reference numerals.

The third detector assembly 70 includes a frangible conduit 32 in the form of an optical fibre 42.

The frangible conduit includes a plurality of interconnected frangible conduit portions 72a, 72b each of which is associated with a respective thyristor clamped assembly 10.

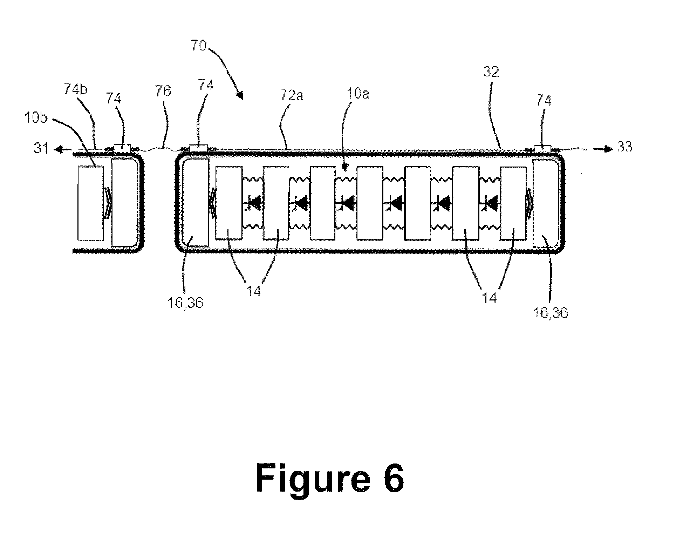

A first frangible conduit portion 72a is fixedly secured to first and second end plates 34, 36 of a first thyristor clamped assembly 10a by respective optical connectors 74, while a second frangible conduit portion 72b is fixedly secured to first and second end plates 34, 36 of a second thyristor clamped assembly 10b (only the second portion 36 is illustrated in Figure 6) by further optical connectors 74.

In other embodiments of the invention, which might employ an electromagnetic radiation source and detector that operate in a different portion of the electromagnetic spectrum, other connectors may be used, i.e. any suitable connector that is able to transmit the corresponding type of electromagnetic radiation.

Further embodiments of the invention may only include a single thyristor clamped assembly 10a and hence only a single associated frangible conduit portion 72a.

An interconnecting frangible conduit portion 76 extends in a relaxed configuration between the first and second thyristor clamped assemblies 10.

In use the third detector assembly 70 functions in an essentially identical manner to the second detector assembly 50.

## Claims

1. A device having at least one at least one thyristor clamped assembly (10) comprising a stack of thyristors (12) in compressive engagement with a first and a second end plates (34, 36), including further a clamping failure detector assembly comprising:
a frangible electromagnetic radiation conduit (32) in the form of an optical fibre (42) extending between the first and second end plates (34, 36) of the at least one thyristor clamped assembly (10);
an electrcmagnetic radiation source (31) arranged in communication with a first end of the frangible conduit (32); and
an electromagnetic radiation detector (33) arranged in communication with a second end of the frangible conduit (32),
the frangible conduit (32) rupturing on movement of the first and second end plates (34, 36) of the at least one thyristor clamped assembly (10) away from one another to interrupt the transmission of electromagnetic radiation from the electromagnetic radiation source (31) to the electromagnetic radiation detector (33); and
the electromagnetic radiation detector (33) indicating a clamping failure when the electromagnetic radiation transmitted from the electromagnetic radiation source (31) is interrupted.

2. A device according to Claim 1 wherein the frangible conduit (32) is wrapped around the at least one thyristor clamped assembly (10).

3. A device according to either Claim 1 or Claim 2 wherein the frangible conduit (32) is fixedly secured to each of the first and second end plates (34, 36) of the at least one thyristor clamped assembly (10).

4. A device according to any of Claims 1 to 3 wherein the frangible conduit (32) extends between the first and second end plates (34, 36) of the at least one thyristor clamping assembly (10) on a midline (38) extending along a middle of the corresponding thyristor clamping assembly or adjacent to said midline (38).

5. A device according to any of Claims 1 to 3 wherein the frangible conduit (32) extends between the first and second end plates (34, 36) of the at least one thyristor clamped assembly (10) on a tensile member line (40) lying coincident with a tensile member (20) acting to clamp the corresponding thyristor clamped assembly (10) together or adjacent to said tensile member line (40).

6. A device according to any of Claims 1 to 5 wherein the frangible conduit (32) includes a plurality of interconnected frangible conduit portions, each frangible conduit portion being associated with a respective thyristor clamped assembly.

7. A device according to any of Claims 1 to 6 wherein the electromagnetic radiation source (31) emits radiation in the visible and/or infrared electromagnetic spectrum.

8. A device according to any of Claims 1 to 7 wherein the electromagnetic radiation source (31) is or includes an LED.

9. A device according to any of Claims 1 to 8, wherein the electromagnetic radiation detector (33) is a visible and/or infrared radiation detector.

10. A method of detecting a clamping failure in at least one thyristor clamped assembly comprising a stack of thyristors (12) in compressive engagement with a first and a second end plates(34, 36), comprising the steps of:
(a) extending a frangible electromagnetic radiation conduit (32) in the form of an optical fibre (42) between the first and second end plates (34, 36) of the at least one thyristor clamped assembly (10) and configuring the frangible conduit (32) to rupture on movement of the first and second end plates of the at least one thyristor clamped assembly away from one another;
(b) arranging an electromagnetic radiation source (31) in communication with a first end of the frangible conduit;
(c) arranging an electromagnetic radiation detector (33) in communication with a second end of the frangible conduit; and
(d) indicating a clamping failure when electromagnetic radiation transmitted from the electromagnetic radiation source (31) to the electromagnetic radiation detector (33) is interrupted on rupture of the frangible conduit (32).

## Patentansprüche

1. Vorrichtung mit wenigstens einer eingespannten Thyristor-Anordnung (10), umfassend einen Stapel Thyristoren (12), der mit einer ersten und einer zweiten Endplatte (34, 36) in Druckberührung steht, wobei ferner eine Spannfehler-Detektoranordnung vorhanden ist, aufweisend eine fragile elektromagnetische Strahlungsleitung (32) in Form einer optischen Faser (42), die sich zwischen den ersten und zweiten Endplatten (34, 36) der wenigstens einen eingespannten Thyristor-Anordnung (10) erstreckt; ferner umfassend eine elektromagnetische Strahlungsquelle (31), die mit einem ersten Ende der fragilen Leitung (32) in Verbindung steht; und einen elektromagnetischen Strahlungsdetektor (33), der mit einem zweiten Ende der fragilen Leitung (32) verbunden ist, wobei die fragile Leitung (32) zerreißt, wenn sich die ersten und zweiten Endplatten (34, 36) der wenigstens einen eingespannten Thyristor-Anordnung (10) auseinander bewegen, um dadurch die Übertragung der elektromagnetischen Strahlung von der elektromagnetischen Strahlungsquelle (31) zu dem elektromagnetischen Strahlungsdetektor (33) zu unterbrechen; und wobei der elektromagnetische Strahlungsdetektor (33) einen Spannfehler anzeigt, sobald die elektromagnetische Strahlung, die von der elektromagnetischen Strahlungsquelle (31) übertragen wird, unterbrochen wird.

2. Vorrichtung nach Anspruch 1, **dadurch gekennzeichnet, daß** die fragile Leitung (32) um wenigstens eine eingespannte Thyristor-Anordnung (10) gewickelt ist.

3. Vorrichtung nach Anspruch 1 oder 2, **dadurch gekennzeichnet, daß** die fragile Leitung (32) sowohl mit der ersten als auch mit der zweiten Endplatte (34, 36) der wenigstens einen eingespannten Thyristor-Anordnung (10) fest verbunden ist.

4. Vorrichtung nach einem der Ansprüche 1 bis 3, **dadurch gekennzeichnet, daß** die fragile Leitung (32) sich zwischen der ersten und der zweiten Endplatte (34,36) der wenigstens einen eingespannten Thyristor-Anordnung (10) auf einer Mittellinie (38) erstreckt, die längs einer Mitte der entsprechenden eingespannten Thyristor-Anordnung verläuft.

5. Vorrichtung nach einem der Ansprüche 1 bis 3, **dadurch gekennzeichnet, daß** die fragile Leitung (32) sich zwischen der ersten und der zweiten Endplatte (34, 36) der wenigstens einen eingespannten Thyristor-Anordnung (10) auf einer Spannungskörperlinie (40) erstreckt, die mit einem Spannungskörper (20) zusammenfällt, der dahingehend wirkt, daß er die eingespannte entsprechende Thyristor-Anordnung (10) spannt, und zwar zusammen oder neben der Spannungskörperlinie (40).

6. Vorrichtung nach einem der Ansprüche 1 bis 5, **dadurch gekennzeichnet, daß** die fragile Leitung (32) eine Vielzahl von miteinander verbundenen fragilen Leitungsteilen aufweist, von denen jeder fragile Leitungsteil einer entsprechenden eingespannten Thyristor-Anordnung zugeordnet ist.

7. Vorrichtung nach einem der Ansprüche 1 bis 6, **dadurch gekennzeichnet, daß** die elektromagnetische Strahlungsquelle (31) Strahlung in dem sichtbaren oder infraroten elektromagnetischen Spektrum aussendet.

8. Vorrichtung nach einem der Ansprüche 1 oder 7, **dadurch gekennzeichnet, daß** die elektromagnetische Strahlungsquelle (31) eine LED ist oder eine LED enthält.

9. Vorrichtung nach einem der Ansprüche 1 bis 8, **dadurch gekennzeichnet, daß** der elektromagnetische Strahlungsdetektor (33) ein sichtbarer und / oder infraroter Strahlungsdetektor ist.

10. Verfahren zur Ermittlung eines Spannfehlers in wenigstens einer eingespannten Thyristor-Anordnung, umfassend einen Stapel Thyristoren (12), der mit einer ersten und einer zweiten Endplatte (34, 36) in Druckberührung steht, **gekennzeichnet durch** die folgenden Schritte:
a) Erstrecken einer fragilen elektromagnetischen Strahlungsleitung (12) in Form einer optischen Faser (42) zwischen den ersten und zweiten Endplatten (34, 36) der wenigstens einen eingespannten Thyristor-Anordnung (10) und Ausbilden der fragilen Leitung (33) derart, daß sie zerreißt, wenn sich die ersten und zweiten Endplatten der wenigstens einen eingespannten Thyristor-Anordnung auseinander bewegen;
b) Anordnen einer elektromagnetischen Strahlungsquelle (31), so daß sie mit einem ersten Ende der fragilen Leitung in Verbindung steht;
c) Anordnen eines elektromagnetischen Strahlungsdetektors (33), so daß er mit einem zweiten Ende der fragilen Leitung in Verbindung steht; und
d) Anzeigen eines Spannfehlers, wenn die elektromagnetische Strahlung, die von der elektromagnetischen Strahlungsquelle (31) zu dem elektromagnetischen Strahlungsdetektor (38) übertragen wird, beim Zerreißen der fragilen Leitung (32) unterbrochen wird.

## Revendications

1. Dispositif ayant au moins un assemblage serré de thyristor (10) comprenant un empilement de thyristors (12) engagés en compression avec des première et seconde plaques d'extrémité (34, 36), incluant en outre un assemblage de détecteur de défaut de serrage comprenant :
un conduit de rayonnement électromagnétique fragile (32) sous la forme d'une fibre optique (42) s'étendant entre les première et seconde plaques d'extrémité (34, 36) du au moins un assemblage serré de thyristor (10) ;
une source de rayonnement électromagnétique (31) agencée en communication avec une première extrémité du conduit fragile (32) ; et
un détecteur de rayonnement électromagnétique (33) agencé en communication avec une seconde extrémité du conduit fragile (32),
le conduit fragile (32) se rompant lors d'un mouvement des première et seconde plaques d'extrémité (34, 36) du au moins un assemblage serré de thyristor (10) en éloignement l'une de l'autre pour interrompre la transmission du rayonnement électromagnétique de la source de rayonnement électromagnétique (31) au détecteur de rayonnement électromagnétique (33) ; et
le détecteur de rayonnement électromagnétique (33) indiquant un défaut de serrage lorsque le rayonnement électromagnétique transmis par la source de rayonnement électromagnétique (31) est interrompu.

2. Dispositif selon la revendication 1, dans lequel le conduit fragile (32) est enveloppé autour du au moins un assemblage serré de thyristor (10).

3. Dispositif selon soit la revendication 1 soit la revendication 2, dans lequel le conduit fragile (32) est arrimé de façon fixe à chacune des première et seconde plaques d'extrémité (34, 36) du au moins un assemblage serré de thyristor (10).

4. Dispositif selon l'une quelconque des revendications 1 à 3, dans lequel le conduit fragile (32) s'étend entre les première et seconde plaques d'extrémité (34, 36) du au moins un assemblage serré de thyristor (10) sur une ligne médiane (38) s'étendant le long d'un milieu de l'assemblage serré de thyristor correspondant ou adjacent à ladite ligne médiane (38).

5. Dispositif selon l'une quelconque des revendications 1 à 3, dans lequel le conduit fragile (32) s'étend entre les première et seconde plaques d'extrémité (34, 36) du au moins un assemblage serré de thyristor (10) sur une ligne d'élément résistant (40) se trouvant en correspondance avec un élément résistant (20) agissant pour serrer l'assemblage serré de thyristor (10) correspondant conjointement ou adjacent à ladite ligne d'élément résistant (40).

6. Dispositif selon l'une quelconque des revendications 1 à 5, dans lequel le conduit fragile (32) inclut une pluralité de portions de conduit fragile interconnectées, chaque portion de conduit fragile étant associée à un assemblage serré de thyristor respectif.

7. Dispositif selon l'une quelconque des revendications 1 à 6, dans lequel la source de rayonnement électromagnétique (31) émet un rayonnement dans le spectre électromagnétique visible et/ou infrarouge.

8. Dispositif selon l'une quelconque des revendications 1 à 7, dans lequel la source de rayonnement électromagnétique (31) est ou inclut une DEL.

9. Dispositif selon l'une quelconque des revendications 1 à 8, dans lequel le détecteur de rayonnement électromagnétique (33) est un détecteur de rayonnement visible et/ou infrarouge.

10. Procédé de détection d'un défaut de serrage dans au moins un assemblage serré de thyristor comprenant un empilement de thyristors (12) engagés en compression avec une première et une seconde plaque d'extrémité (34, 36), comprenant les étapes de :
(a) extension d'un conduit de rayonnement électromagnétique fragile (32) sous la forme d'une fibre optique (42) entre les première et seconde plaques d'extrémité (34, 36) du au moins un assemblage serré de thyristor (10) et configuration du conduit fragile (32) pour qu'il se rompe lors d'un déplacement des première et seconde plaques d'extrémité du au moins un assemblage bridé de thyristor en éloignement l'une de l'autre ;
(b) agencement d'une source de rayonnement électromagnétique (31) en communication avec une première extrémité du conduit fragile ;
(c) agencement d'un détecteur de rayonnement électromagnétique (33) en communication avec une seconde extrémité du conduit fragile ; et
(d) indication d'un défaut de serrage lorsqu'un rayonnement électromagnétique transmis de la source de rayonnement électromagnétique (31) au détecteur de rayonnement électromagnétique (33) est interrompu lors de la rupture du conduit fragile (32).
